# EUROPEAN PATENT APPLICATION

(11) **EP 4 391 750 A1**
(43) Date of publication of application: **26.06.2024**
(21) Application number: 22306932.9
(22) Date of filing: 19.12.2022
(51) Int. Cl.: H05K 7/20

(54) **CRYOGENIC SYSTEM WITH INERT GAS ISOLATION**

(71) Applicant: Airbus SAS, 31700 Blagnac (FR)
(72) Inventor: JACOB, Timin, 82024 TAUFKIRCHEN (DE); YBANEZ, Ludovic, 31700 BLAGNAC (FR); TASSISTO, Matteo, 31700 BLAGNAC (FR); KHARCHE, Swapnil, 31700 BLAGNAC (FR); SURAPANENI, Ravi Kiran, 82024 TAUFKIRCHEN (DE); GALLA, Gowtham, 82024 TAUFKIRCHEN (DE)
(74) Representative: Cabinet Le Guen Maillet

(57) **Abstract**

A cryogenic system (2) intended to cool down components and comprising a housing (210) and a thermal coupling system able to thermally connect a cryogenic fluid tank and the housing (210), the housing (210) being airtight and being arranged to contain at least one component (C), the cryogenic system (2) comprises: an inert fluid tank (20), the inert fluid consisting of at least one of the inert gas or nitrogen; a first opening (21) connected to the inert fluid tank (20); a second opening (22) connected to a relief valve (25) configured to release gas from the housing (210) when the pressure inside the housing exceeds a predefined pressure value; a third opening (23) connected to an exhaust line (203), and a shut-off valve (24) disposed on the exhaust line (203). The component is thus thermally and chemically isolated from the outside of the housing without using vacuum.

## Description

### TECHNICAL FIELD

The present invention generally relates to the field of cryogenics and more specifically to a cryogenic system utilizing an inert gas to isolate a component intended to be cooled by the cryogenic system.

### BACKGROUND ART

Currently, new generation electric aircrafts are being developed, using fuel cell technology powered by liquid hydrogen. Such electric aircrafts require efficient electrical systems with high power electrical transfers and low electrical losses resulting from the resistivity of components. Superconducting electrical systems with high electrical efficiency can be achieved through cryogenics and are therefore used in electric aircrafts.

Since many elements of an aircraft must be cooled, it is interesting to use cryogenics to cool further components in the aircraft. Cold sources used in cryogenics are indeed already available. Drawbacks may however be observed when using cryogenics, such as condensation or ice formation both inside and outside a cryostat housing containing the components to be cooled. Condensation and ice formation inside the cryostat housing must be particularly avoided as they may reduce performance of the cooled components. Vacuum is usually used in the cryostat housing to avoid such phenomena. The use of vacuum provides a chemically inert environment in the cryostat housing and a thermal insulation between the components to be cooled and the environment outside the cryostat housing.

However, the implementation of vacuum requires heavy and expensive systems. In addition, the operation of such systems is sensitive to leakage and additional safety devices are required. The cooled components shall furthermore be able to withstand the vacuum, which requires additional testing.

It is desirable to overcome the aforementioned drawbacks of the prior art. It is more particularly desirable to provide a solution that enables the cooling of aircraft components without leading to condensation and formation of ice. It is also desirable to provide a solution which is lightweight, low-priced and easy to implement.

### INVENTION DISCLOSURE

The present invention concerns a cryogenic system intended to cool down at least one electrical or electronical component, the cryogenic system comprising a cryogenic fluid storage tank, a housing and a thermal coupling system able to thermally connect the cryogenic fluid storage tank and the housing. The housing is airtight and is arranged to contain the at least one electrical or electronical component. The cryogenic system comprises: an inert fluid tank configured to deliver an inert fluid, the inert fluid consisting of at least one chemical element belonging to the family of inert gases or to nitrogen; a first opening connected to the inert fluid tank; means configured to inject the inert fluid into the housing at a first predefined pressure value; a second opening connected to a relief valve configured to release gas from the housing only when the pressure inside the housing exceeds a second predefined pressure value, the second predefined pressure value being lower than the first predefined pressure value; a third opening connected to an exhaust line being connected to air at a third predefined pressure value, the third predefined pressure value being lower than the first predefined pressure value and equal to or lower than the second predefined pressure value; a shut-off valve disposed on the exhaust line; and a control unit comprising electronic circuitry configured to maintain the shut-off valve in an open position as long as an inert fluid proportion inside the housing is lower than a predefined proportion threshold and to close the shut-off valve when the inert fluid proportion inside the housing reaches or exceeds the predefined proportion threshold.

It is thus possible to evacuate and replace air from inside the housing with an inert gas environment by opening the shut-off valve and injecting the inert fluid at the first predefined value. It is furthermore possible to maintain the inert gas environment during a cooling of the at least one electrical or electronic component inside the housing by closing the shut-off valve and to maintain the inert gas environment at the second predefined pressure value by using the relief valve. The at least one electrical or electronic component is therefore thermally and chemically isolated from the outside of the housing by the inert gas environment generated inside the housing, thus reducing condensation and ice formation inside the housing, without implementing vacuum inside the housing. Vacuum equipment is therefore not necessary.

According to a particular feature, the cryogenic system further comprises a composition sensor configured to detect a gas composition inside the housing and the control unit comprises electronic circuitry further configured to activate and deactivate the thermal coupling system depending on the detected gas composition.

According to a particular feature, the inert fluid tank is configured to store the inert fluid in gaseous form.

According to a particular feature, the inert fluid tank is configured to store the inert fluid in liquid form, the cryogenic system further comprising a first heater arranged to heat the inert fluid so as to vaporize the inert fluid into gaseous form.

According to a particular feature, the first heater is disposed on an injection line connecting the inert fluid tank to the first opening of the housing, the inert fluid being injected into the housing in gaseous form.

According to a particular feature, the first heater is disposed inside the housing, the inert fluid being injected into the housing in liquid form.

According to a particular feature, the cryogenic system further comprises an inert fluid bypass line configured to bypass the housing from the exhaust line back to the injection line connecting the inert fluid tank to the first opening of the housing, the cryogenic system further comprising a flow control valve located at an inlet of the inert fluid bypass line.

According to a particular feature, the cryogenic system further comprises a multilayer thermal insulator disposed on the surface of the housing.

According to a particular feature, the cryogenic system further comprises interstitial areas, each interstitial area being delimited by two superposed layers of the multilayer thermal insulator, each interstitial area comprising an opening connected to the inert fluid tank.

According to a particular feature, the cryogenic system further comprises a plurality of second heaters distributed over the surface of the housing.

The present invention also concerns an aircraft comprising at least one aforementioned cryogenic system in any one of its embodiments.

According to a particular feature, the aircraft comprises a global cooling system and the inert fluid used by the at least one cryogenic system is diverted from the global cooling system.

The present invention also concerns a method for isolating at least one electrical or electronic component in a cryogenic system, the cryogenic system comprising a cryogenic fluid storage tank, a housing and a thermal coupling system able to thermally connect the cryogenic fluid storage tank and the housing, the housing being airtight and being arranged to contain at least one electrical or electronic component. The method comprises:
- injecting an inert fluid into the housing at a first predefined pressure value via a first opening of the cryogenic system, said inert fluid consisting of at least one chemical element belonging to the family of inert gas or to nitrogen,
- enabling a gas release from the housing via a second opening of the cryogenic system only when the pressure inside the housing exceeds a second predefined pressure value, and further when an inert fluid proportion inside the housing reaches or exceeds a predefined proportion threshold, the second predefined pressure value being lower than the first predefined pressure value, and
- enabling a gas release from the housing via a third opening of the cryogenic system as long as the inert fluid proportion inside the housing is lower than the predefined proportion threshold, when the pressure inside the housing exceeds a third predefined pressure value, the third predefined pressure value being lower than the first predefined pressure value.

According to a particular feature, the method further comprises activating the thermal coupling system when the inert fluid proportion inside the housing reaches or exceeds the predefined proportion.

### BRIEF DESCRIPTION OF THE FIGURES

The characteristics of the invention will emerge more clearly from a reading of the following description of an example of embodiment, said description being produced with reference to the accompanying drawings, among which:
[Fig. 1] schematically represents an electric aircraft comprising a cryogenic system;
[Fig. 2] schematically represents the cryogenic system according to a first embodiment;
[Fig. 3] schematically represents the cryogenic system according to the first embodiment further comprising a bypass line;
[Fig. 4A] schematically represents the cryogenic system comprising a multilayer insulator on a surface of a housing;
[Fig. 4B] schematically represents the cryogenic system comprising the multilayer insulator according to a particular embodiment;
[Fig. 5] schematically represents the cryogenic system comprising heaters;
[Fig. 6A] schematically represents the cryogenic system according to a second embodiment;
[Fig. 6B] schematically represents the cryogenic system according to a third embodiment;
[Fig. 7A] schematically represents the cryogenic system according to a fourth embodiment;
[Fig. 7B] schematically represents the cryogenic system according to a fifth embodiment;
[Fig. 7C] schematically represents the cryogenic system according to a sixth embodiment;
[Fig. 8] schematically represents a method for isolating components in the cryogenic system; and
[Fig. 9] schematically represents an example of a hardware architecture of a control unit of the cryogenic system.

### DETAILED DESCRIPTION OF THE WAYS OF CARRYING OUT THE INVENTION

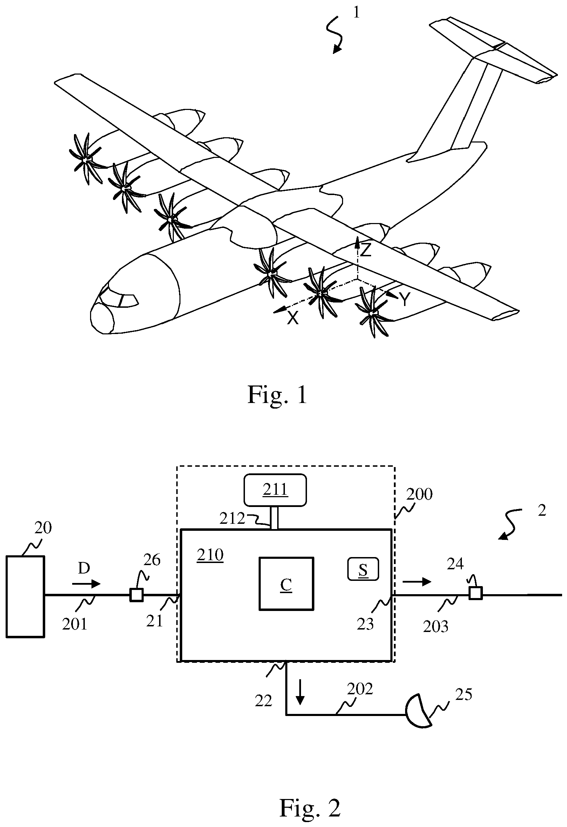

**Fig. 1** schematically represents an electric aircraft 1 comprising a cryogenic system 2.

**Fig. 2** schematically represents the cryogenic system 2 according to a first embodiment.

The cryogenic system 2 comprises a cryostat 200 comprising a housing 210 being arranged to contain at least one electrical or electronic component C of the aircraft 1 which is intended to be cooled by the cryogenic system 2. The housing 210 is configured to ensure an airtight seal. An airtight seal means that no fluid can pass from inside to outside the housing 210 when it is closed except through a first, a second and a third opening 21, 22, 23 of the cryogenic system 2. In other words, molecules of fluid cannot pass through a wall of the housing 210.

The cryostat 200 of the cryogenic system 2 further comprises a cryogenic fluid storage tank211, containing a cryogenic fluid, and a thermal coupling system 212. The thermal coupling system 212 can thermally connect the cryogenic fluid storage tank 211 with the housing 210. The thermal connection can for example be achieved by means of a circulation of the cryogenic fluid in a cooling line passing successively through the cryogenic fluid storage tank 211 and the housing 210. Therefore, during a cooling operation, the thermal coupling system is activated and a heat transfer between the component C and the cryogenic fluid is achieved, enabling the component C to be cooled and maintained at a predefined temperature. When the thermal coupling system is deactivated, the heat transfer stops, thus preventing the cooling or the temperature stabilization of the component C.

The cryogenic system 2 comprises an inert fluid tank 20 that contains an inert fluid. The inert fluid is defined as a fluid consisting of at least one chemical element belonging to the family of inert gas, i.e. noble gas, or to nitrogen.

The cryogenic system 2 further comprises the first opening 21 connected, via an injection line 201, to the inert fluid tank 20. The cryogenic system 2 comprises means configured to inject the inert fluid into the housing at a first predefined pressure value which is higher than an air pressure determined outside the housing 210 of the cryogenic system 2, i.e. the atmospheric pressure. According to a first example, the inert fluid tank 20 can deliver the inert fluid at a first predefined pressure value, making then possible to inject the inert fluid into the housing 210 at the first predefined pressure value. In this case, the injecting means configured to inject the inert fluid into the housing at a first predefined pressure value are the inert fluid tank 20. According to a second example, the inert fluid is stored into the fluid tank 20 at a higher pressure than the first predefined pressure value and the cryogenic system 2 comprises a pressure control valve 26 disposed on the injection line 201 and controlling the inert fluid pressure injected into the housing 210 at the first opening 21. In this case, the injecting means configured to inject the inert fluid into the housing at a first predefined pressure value are the pressure control valve 26.

According to the first embodiment of the cryogenic system, the inert fluid stored inside the tank 20 is stored in gaseous form. The inert fluid is therefore transported through the injection line 201 and injected into the housing 210 in gaseous form.

The cryogenic system 2 further comprises the second opening 22 connected to a relief valve 25 via a release line 202. The relief valve 25 is configured to release gas from inside the housing 210 when the pressure inside the housing 210 exceeds a second predefined pressure value. The second predefined pressure value is lower than the first predefined pressure value. According to an embodiment, the second predefined pressure value is equal to the air pressure determined outside the housing 210 of the cryogenic system 2, i.e. the atmospheric pressure. The gas released by the relief valve is then transported to an exhaust device of the aircraft 1.

The cryogenic system 2 further comprises the third opening 23 connected to an exhaust device of the aircraft 1 via an exhaust line 203. The exhaust device is connected to air outside the housing 210 at a third predefined pressure value which is lower than the first predefined pressure value and is equal to or lower than the second predefined pressure value. Advantageously, the third predefined pressure value is lower than the second predefined pressure value. According to an embodiment, the third predefined pressure value is equal to the atmospheric pressure and the exhaust device is connected to air at the atmospheric pressure. In other words, the pressure of a gas evacuated from the housing 210 through the exhaust line 203 drops to the atmospheric pressure at an outlet of the exhaust line 203. A shut-off valve 24 is disposed on the exhaust line 23 downstream from the housing 210 according to a predefined direction D of flow of fluid from the injection line 201 to the exhaust line 203 through the housing 210. The shut-off valve 24 comprises two positions. In an open position, the gas coming from the housing 210 is able to flow through the shut-off valve 24, and therefore to flow through the exhaust line 23 up to the exhaust device. In a closed position, the shut-off valve 24 stops the flow of the gas coming from the housing 210 and therefore prevents the circulation of the gas inside the exhaust line 23.

When the circulation of a fluid is enabled through the injection line 201, the release line 202 and the exhaust line 203, the fluid circulates according to the predefined direction D represented by an arrow on Fig. 2, i.e. from the inert fluid tank to the housing 210, from the housing 210 to the relief valve 25 and from the housing 210 to the shut-off valve 24. The terms upstream and downstream used in the description refer to the predefined direction D of circulation of the fluid. A pump (unrepresented) may be disposed on the injection line 201 in order to activate the circulation of the inert fluid through the injection line 201.

The cryogenic system 2 comprises a composition sensor S disposed inside the housing 210. The composition sensor S is able to detect gas concentration and determine the gas composition inside the housing 210. The composition sensor S can specifically determine an information representative of the proportion of the inert gas in the housing 210, i.e. of the ratio of the inert fluid to a total amount of gas present in the housing 210.

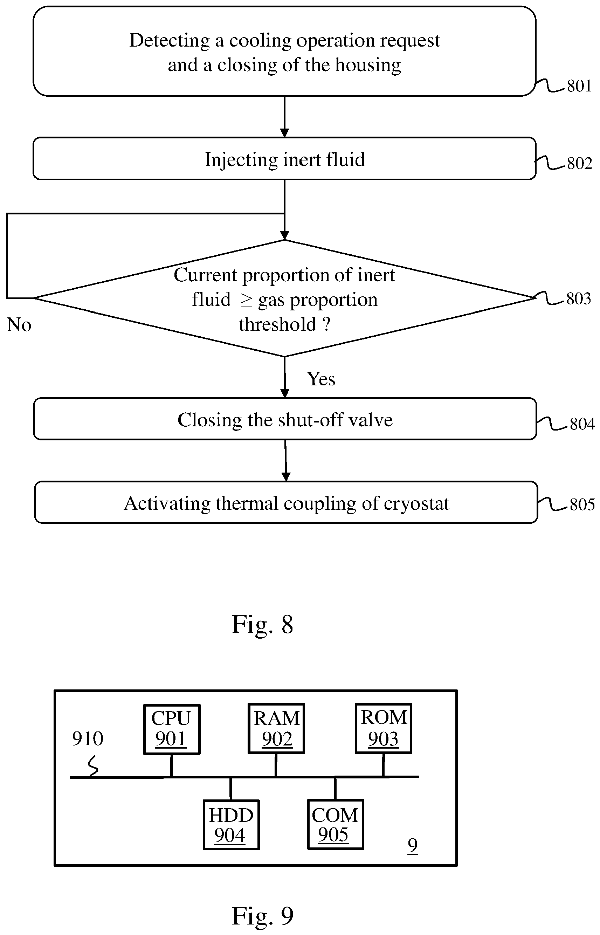

The cryogenic system 2 further comprises a control unit 9 (represented in Fig. 9) configured to activate and deactivate the thermal coupling system depending on the detected gas composition by the composition sensor S. The control unit 9 receives an information representative of a current proportion of inert gas in the housing 210 from the composition sensor S. The control unit 9 compares the received information to a predefined gas proportion threshold. As long as the proportion of the inert fluid in the housing 210 is lower than the predefined gas proportion threshold, the control unit 9 keeps the thermal coupling deactivated. When the proportion of the inert fluid in the housing 210 reaches or exceeds the predefined gas proportion threshold, the control unit 9 activates the thermal coupling so that an operation of cooling can be initialized (as presented thereafter at a step 805 in Fig. 8).

The control unit 9 can further control the shut-off valve 24 depending on the detected gas composition by the composition sensor S. The shut-off valve 24 is set in the open position as long as the proportion of the inert fluid in the housing 210 is lower than the predefined gas proportion threshold. The pressure difference between the first predefined pressure (i.e. the pressure of the inert fluid injected inside the housing 210) and the atmospheric pressure outside the housing 210 causes an evacuation of gas from inside to outside the housing 210. This allows the evacuation of gas initially present in the housing 210 that are unwanted during the cooling operation. When the proportion of the inert fluid in the housing 210 reaches or exceeds the predefined gas proportion threshold, the control unit 9 sets the shut-off valve 24 into the closed position thus stopping the gas flowing from the housing 210 through the exhaust line 203. The pressure inside the housing 210 then results from the relief valve 25 and is equal to the second predefined pressure value, given that the second predefined pressure value is lower than the first predefined pressure value. The pressure inside the housing 210 can therefore be regulated at the second predefined pressure value by means of the relief valve 25 both with the shut-off valve 24 set in the closed position during the cooling operation.

It is therefore possible to isolate the at least one electrical or electronic component C thermally and chemically from the outside of the housing 210 by means of a generation of an inert fluid environment inside the housing 210. As the inert fluid is chemically inert and does not contain water molecules, condensation and ice formation inside the housing are highly reduced. The inert fluid environment further prevents any other chemical reaction between the environment inside the housing 210 and the at least one electrical or electronic component C which could occur because of a long duration exposure or a cooling at very low temperatures.

In addition, the presence of inert fluid in gaseous form inside the housing 210 provides a thermal isolation between the at least one electrical or electronic component C and the outside of the housing 210. This provides both a reduction of condensation and ice formation outside the housing 210 and enables a more efficient cooling operation of the at least one electrical or electronic component C by the cryostat 200. The heat generated inside the housing 210 results mainly from the heat produced by the at least one electrical or electronic component C and transferred outside of the housing 210 only by a convection transfer mechanism of the inert fluid.

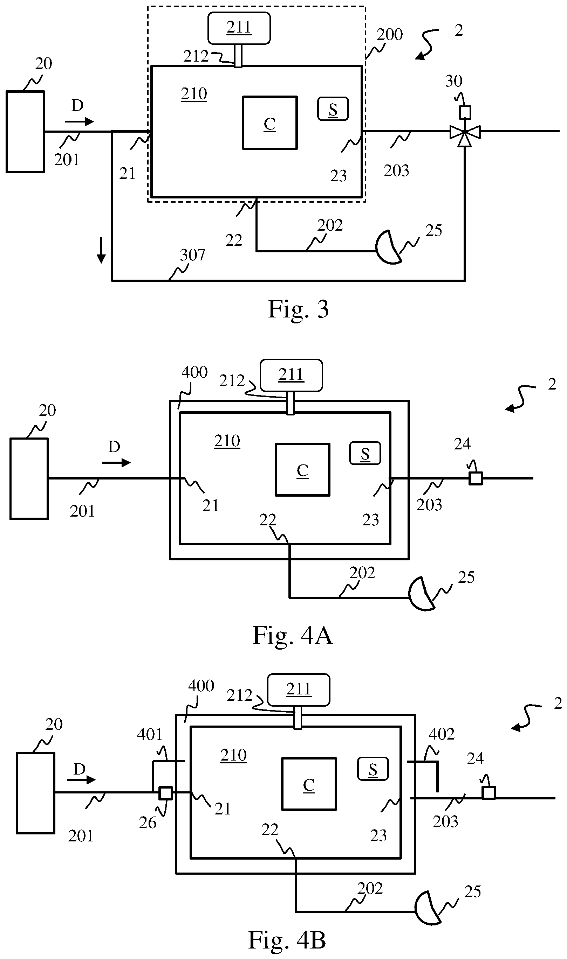

**Fig. 3** schematically represents the cryogenic system according to the first embodiment further comprising a bypass line 307.

The bypass line 307 enables the inert fluid to circulate from the exhaust line 203 back to the injection line 201 without circulating inside the housing 210, thus bypassing the housing 210. The cryogenic system further comprises a flow control valve 30 located at an inlet of the inert fluid bypass line 307, i.e. at a junction between the bypass line 307 and the exhaust line 203. The flow control valve 30 comprises at least two positions. A first position enables the gas to flow from the housing 210 through the exhaust line 203 up to the exhaust device, without flowing into the bypass line 307. A second position enables the gas to flow from the housing 210 into the bypass line 307 without flowing to the exhaust device. The flow control valve 30 therefore enables a selection between the exhaust line 203 and the bypass line 307 to let the gas flow from the housing 210. In addition, the flow control valve 30 carries out functions of the shut-off valve 24. The open position of the shut-off valve 24 is achieved by the first position of the flow control valve 30 whereas the closed position of the shut-off valve 24 is achieved by the second position of the flow control valve 30.

An outlet of the bypass line 307 is located on the injection line 201 between the inert fluid tank 20 and the housing 210 and is disposed upstream the pressure control valve 26 if applicable.

When the proportion of the inert fluid in the housing 210 reaches or exceeds the predefined gas proportion threshold, the flow control valve 30 is actuated, for example by the control unit 9, to the second position, thus allowing gas flowing from the housing 210 to flow into the bypass line 307. It is thus possible to reuse a portion of the inert fluid flowing out from the housing 210 by reintroducing it inside the housing 210. Costs resulting from the utilization of inert fluids are thus reduced.

**Fig. 4A** schematically represents the cryogenic system 2 comprising a multilayer insulator 400 on a surface of the housing 210.

The multilayer insulator 400 is a thermal insulator composed of multiple superposed insulating layers enabling a reduction of thermal losses. The multilayer insulator 400 is disposed on the surface of the housing 210 and advantageously on the whole surface of the housing 210. The first, second and third openings 21, 22, 23 remain connected to respectively the injection, release and exhaust lines 201, 202 and 203 by means of respective openings in the multilayer insulator 400 enabling the injection, release and exhaust lines 201, 202 and 203 to connect to the housing 210. During a cooling operation, the multilayer insulator 400 reduces the heat transfer from outside the housing 210 to inside the housing 210 which is due to thermal radiation. The multilayer insulator 400 therefore protects against thermal leaks and prevents or limits condensation and ice formation on an outside surface of the housing 210.

**Fig. 4B** schematically represents the cryogenic system 2 comprising the multilayer insulator 400 on the surface of the housing 210 according to a particular embodiment. In this embodiment, the multilayer insulator 400 comprises interstitial areas, each interstitial area being delimited by two superposed layers of the multilayer insulator 400. Each interstitial area comprises an opening connected to the inert fluid tank 20 via a distribution line 401 making possible to fill the interstitial area with inert fluid. The cryogenic system 2 may further comprise a collecting line 402 enabling the inert fluid to circulate in each interstitial area. The thermal insulation is then improved thanks to inert fluid insulation. Thus, the formation of condensation and ice on an outside surface of the housing 210 is further reduced.

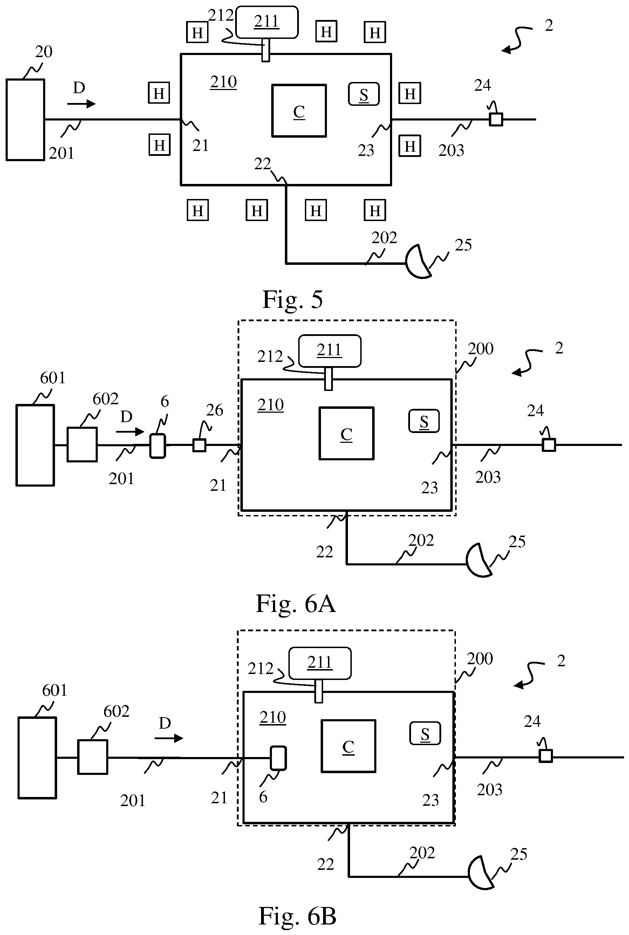

**Fig. 5** schematically represents the cryogenic system 2 comprising heaters H, here referred to as second heaters H. The second heaters H are attached to the housing 210 and distributed over the external surface of the housing 210. In other words, the second heaters H are arranged in an array disposal all around the housing 210. The second heaters H can be activated, for example by the control unit 9, to produce heat during a cooling operation, thus preventing the condensation and formation of ice on an outside surface of the housing 210.

**Fig. 6A** schematically represents the cryogenic system 2 according to a second embodiment. The cryogenic system 2 comprises the cryostat 200 comprising the housing 210, the cryogenic fluid storage tank and the thermal coupling system, so as the first, second and third openings 21, 22, 23 connected respectively to the injection, release and exhaust lines 201, 202, 203, the relief valve 25, the shut-off valve 24 and the composition sensor S and control unit 9 in a similar way as the first embodiment.

According to the second embodiment of the cryogenic system 2, the first opening 21 is connected, via the injection line 201 to a main inert fluid tank 601. The cryogenic system 2 further comprises an intermediate inert fluid storage tank 602. Moreover, the inert fluid is stored inside the main inert fluid tank 601 and the intermediate inert fluid tank 602 is stored in liquid form. The inert fluid is transported via the injection line 201 in liquid form up to a first heater 6. The first heater 6 heats the liquid inert fluid so as to vaporize or boil the liquid into gaseous form. The first heater 6 thus differs from the second heaters H in that the second heaters H are intended to heat the outside surface of the housing 210 whereas the first heater is intended to heat the liquid inert fluid. The second heaters H therefore perform a different function than the first heater 6.

The first heater 6 according to the second embodiment is disposed on the injection line 201 between the intermediate inert fluid storage tank 602 and the first opening 21. The inert fluid is therefore transported through the injection line 201 downstream the first heater 6 in gaseous form and is injected into the housing 210 in gaseous form.

**Fig. 6B** schematically represents the cryogenic system 2 according to a third embodiment. The cryogenic system 2 according to the third embodiment comprises the same elements as the second embodiment but differs from the second embodiment in that the first heater 6 is located inside the housing 210 at an extremity of the injection line 201. Then, the inert fluid is transported through the whole injection line 201 and injected into the housing 210 in liquid form and transformed into gaseous from only inside the housing 210.

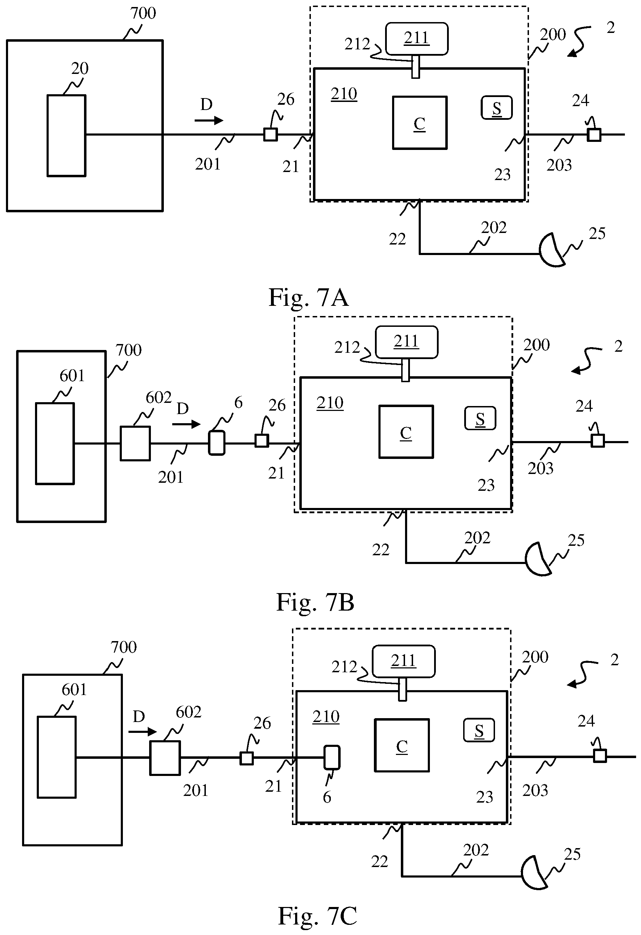

**Fig. 7A** schematically represents the cryogenic system 2 according to a fourth embodiment. The cryogenic system 2 comprises the same features as the first embodiment. In addition, the inert fluid tank 20 of the cryogenic system 2 belongs to a global cooling system 700 of the aircraft 1. In other words, the inert fluid is diverted from the main global cooling system 700. The main cooling system 700 is a system performing a cooling of equipment in the aircraft 1 based on inert fluid cooling loops.

The global cooling system 700 comprises the inert fluid tank 20 containing the inert fluid in gaseous form. The cryogenic system 2 uses available inert fluid of the global cooling system 700. Thus, no additional storage tank is required to store the inert fluid. The inert fluid pooling between the preexisting global cooling system 700 and the cryogenic device 2 reduces weight and enables saving space inside the aircraft 1.

**Fig. 7B** schematically represents the cryogenic system 2 according to a fifth embodiment. According to the fifth embodiment, the cryogenic system 2 comprises the same features as the second embodiment. In addition, the main inert fluid tank 601 of the cryogenic system 2 belongs to a global cooling system 700 of the aircraft 1. The inert fluid is therefore diverted from the main global cooling system 700.

The global cooling system 700 comprises the main inert fluid tank 601 containing the inert fluid in liquid form. The cryogenic system 2 uses available inert fluid of the global cooling system 700. Thus, no additional storage tank is required to store the inert fluid. The inert fluid pooling between the preexisting global cooling system 700 and the cryogenic device 2 reduces the weight and allows to save space inside the aircraft 1.

**Fig. 7C** schematically represents the cryogenic system 2 according to a sixth embodiment. The cryogenic system comprises the same features as the third embodiment. In addition, the main inert fluid tank 601 of the cryogenic system 2 belongs to a global cooling system 700 of the aircraft 1. The inert fluid is therefore diverted from the main global cooling system 700.

The global cooling system 700 comprises the main inert fluid tank 601 containing the inert fluid in liquid form. The cryogenic system 2 uses available inert fluid of the global cooling system 700. Thus, no additional storage tank is required to store the inert fluid. The inert fluid pooling between the preexisting global cooling system 700 and the cryogenic device 2 reduces weight and enables saving space inside the aircraft 1.

Combinations of the various embodiments disclosed herein are possible. The cryogenic system 2 according to the first embodiment may therefore simultaneously comprise the bypass line 307 as represented in Fig. 3 with a multilayer insulator 400 as represented in Fig. 4A or 4B and/or the second heaters H as represented in Fig. 5. The cryogenic system 2 according to the first embodiment may include a combination of the multilayer insulator 400 and the second heaters H. In a similar way, the cryogenic system 2 according to the second and third embodiments as represented in Figs. 6A and 6B may further comprise the second heaters H and/or the multilayer insulator 400 as represented in Fig. 4A or 4B. The cryogenic system 2 according to the second embodiment as represented in Fig. 6A may further comprise a bypass line 307. In this case, the outlet of the bypass line 307 is located between the first heater 6 and the first opening 21. The cryogenic system 2 according to the fourth, fifth and sixth embodiments, as represented in respective Fig. 7A, 7B and 7C may further comprise the second heaters H and/or the multilayer insulator 400 and/or further the bypass line 307 for the third and fourth embodiments.

**Fig. 8** schematically represents a method for isolating the at least one electrical or electronic component C in the cryogenic system 2, implemented by the control unit 9.

In a step 801, the cryogenic system 2 is in an initial configuration in which the injection line 201 is closed, for example thanks to an injection valve (unrepresented) disposed on the injection line 201 and set in a closed position. The control unit 9 detects a cooling operation request. A cooling operation request is sent to the control unit 9 in order to indicate that the cooling of the at least one electrical or electronic component C is required. The cooling operation request is for example emitted by an aircraft management system, either manually by pressing on a dedicated button, or automatically (typically by avionics). In the step 801, the control unit 9 detects the closing of the housing 210, thus ensuring the airtight seal of the housing 210.

In a following step 802, the control unit 9 injects the inert fluid into the housing 210, for example by opening the injection valve and/or by activating a pump disposed on the injection line 201. In the case the shut-off valve 24 is closed in the initial configuration, the control unit 9 opens the shut-off valve 24. The open position of the shut-off valve 24 enables the evacuation of gas from the housing 210 due to the pressure difference between the first predefined pressure value of the inert fluid at the first opening 21 and the atmospheric pressure at the exhaust device of the exhaust line 203. This enables eliminating unwanted gas for the cooling operation, resulting in an increase of the inert fluid proportion inside the housing 210, i.e. of the ratio of inert fluid to a total amount of gas present in the housing 210.

In a following step 803, the control unit 9 determines, from an information representative of a current gas composition inside the housing 210 received from the composition sensor S, if the proportion of the inert fluid present in the housing 210 is equal to or greater to the predefined gas proportion threshold. If it is the case, a step 804 is performed. Otherwise, the control unit 9 resumes the step 803 with further information subsequently received from the composition sensor S. The composition sensor S regularly captures and sends information representative of the gas composition information, for example every second.

At the step 804, the proportion of inert fluid inside the housing 210 reaches or exceeds the predefined gas proportion threshold, thus fulfilling required conditions for cooling down the at least one electrical or electronic component C. The unit control 9 then closes the shut-off valve 24, in order to enable a regulation of the pressure in the housing 210 by the relief valve 25 at the second predefined pressure value.

In a following step 805, the control unit 9 activates the thermal coupling of the cryostat 200 to initialize the cooling operation.

The step 805 can be performed once the step 804 has been achieved, when the pressure inside the housing 210 is equal to the second predefined pressure value, which can be detected by means of a pressure sensor.

Alternatively, the step 805 can be performed simultaneously with the step 804, in other words as soon as the predefined gas proportion threshold is reached in the step 803.

**Fig. 9** schematically represents an example of hardware architecture of the control unit 9 of the cryogenic system 2.

An example of hardware architecture of the control unit 9 includes the following components interconnected by a communications bus 910: a processor or CPU (Central Processing Unit) 901, which may also be a microprocessor, or a microcontroller; a RAM (Random-Access Memory) 902; a ROM (Read-Only Memory) 903; a device adapted to read information stored on a storage medium, such as an SD (Secure Digital) card reader or an HDD (Hard Drive Disk) 904; and a communication interface enabling the control unit 9 to receive information from the aircraft management system, the composition sensor S, and from the pressure sensor (if any), and to transmit instructions to the injection valve and the shut-off valve 24.

The processor 901 is capable of executing instructions loaded into the RAM 902 from the ROM 903 or from an external memory, such as an SD card. After the control unit 9 has been powered on, the processor 901 is capable of reading instructions from the RAM 902 and executing these instructions. The instructions form one computer program that causes the processor 901 to perform some, or all the steps and behavior described herein with respect to the control unit 9.

Any and all steps and behavior described herein with respect to the control unit 9 may be implemented in software by execution of a set of instructions or program by a programmable computing machine, such as a PC (Personal Computer), a DSP (Digital Signal Processor) or a microcontroller; or else implemented in hardware by a machine or a dedicated chip or chipset, such as an FPGA (Field-Programmable Gate Array) or an ASIC (Application-Specific Integrated Circuit). In general terms, the control unit 9 thus comprises electronic circuitry configured for implementing any and all steps and behavior described herein with respect to the control unit 9.

## Claims

1. A cryogenic system (2) intended to cool down at least one electrical or electronic component (C), the cryogenic system (2) comprising a cryogenic fluid storage tank, a housing (210) and a thermal coupling system able to thermally connect the cryogenic fluid storage tank and the housing (210), the housing (210) being airtight and being arranged to contain the at least one electrical or electronic component (C), the cryogenic system (2) being **characterized in that** it comprises:
- an inert fluid tank (20, 602) configured to deliver an inert fluid, the inert fluid consisting of at least one chemical element belonging to the family of inert gas or to nitrogen,
- a first opening (21) connected to the inert fluid tank (20, 602),
- means configured to inject the inert fluid into the housing (210) at a first predefined pressure value,
- a second opening (22) connected to a relief valve (25) configured to release gas from the housing (210) only when the pressure inside the housing exceeds a second predefined pressure value, the second predefined pressure value being lower than the first predefined pressure value,
- a third opening (23) connected to an exhaust line (203) being connected to air at a third predefined pressure value, the third predefined pressure value being lower than the first predefined pressure value and equal to or lower than the second predefined pressure value,
- a shut-off valve (24) disposed on the exhaust line (203), and
- a control unit (9) comprising electronic circuitry configured to maintain the shut-off valve (24) in an open position as long as an inert fluid proportion inside the housing is lower than a predefined proportion threshold and to close the shut-off valve (24) when the inert fluid proportion inside the housing reaches or exceeds the predefined proportion threshold.

2. The cryogenic system according to claim 1, further comprising a composition sensor (S) configured to detect a gas composition inside the housing (210), and wherein the control unit (9) comprises electronic circuitry further configured to activate and deactivate the thermal coupling system depending on the detected gas composition.

3. The cryogenic system according to one of claims 1 and 2, wherein the inert fluid tank (20) is configured to store the inert fluid in gaseous form.

4. The cryogenic system according to one of claims 1 and 2, wherein the inert fluid tank (602) is configured to store the inert fluid in liquid form, the cryogenic system further comprising a first heater (6) arranged to heat the inert fluid so as to vaporize the inert fluid into gaseous form.

5. The cryogenic system according to claim 4, wherein the first heater (6) is disposed on an injection line (201) connecting the inert fluid tank (602) to the first opening (21) of the housing (210), the inert fluid being injected into the housing (210) in gaseous form.

6. The cryogenic system according to claim 4, wherein the first heater (6) is disposed inside the housing (210), the inert fluid being injected into the housing in liquid form.

7. The cryogenic system according to any one of claims 3 to 5, further comprising an inert fluid bypass line (307) configured to bypass the housing from the exhaust line (203) back to the injection line (201) connecting the inert fluid tank (20, 602) to the first opening (21) of the housing (210), the cryogenic system further comprising a flow control valve (30) located at an inlet of the inert fluid bypass line (307).

8. The cryogenic system according to any one of claims 1 to 7, further comprising a multilayer thermal insulator (400) disposed on the surface of the housing (210).

9. The cryogenic system according to claim 8, further comprising interstitial areas, each interstitial area being delimited by two superposed layers of the multilayer thermal insulator (210), each interstitial area comprising an opening connected to the inert fluid tank (20).

10. The cryogenic system according to any one of claims 1 to 9, further comprising a plurality of second heaters (H) distributed over the surface of the housing (210).

11. An aircraft (1) **characterized in that** it comprises at least one cryogenic system (2) according to any one of claims 1 to 10.

12. The aircraft (1) according to claim 11, wherein the aircraft (1) comprises a global cooling system (700) and wherein the inert fluid used by the at least one cryogenic system (2) is diverted from the global cooling system (700).

13. A method for isolating at least one electrical or electronic component (C) in a cryogenic system (2), the cryogenic system (2) comprising a cryogenic fluid storage tank (211), a housing (210) and a thermal coupling system (212) able to thermally connect the cryogenic fluid storage tank and the housing (210), the housing (210) being airtight and being arranged to contain at least one electrical or electronic component (C), the method being **characterized in that** it comprises:
- injecting (802) an inert fluid into the housing at a first predefined pressure value via a first opening (21) of the cryogenic system (2), said inert fluid consisting of at least one chemical element belonging to the family of inert gas or to nitrogen,
- enabling a gas release (804) from the housing (210) via a second opening (22) of the cryogenic system (2) only when the pressure inside the housing exceeds a second predefined pressure value, and further when the inert fluid proportion inside the housing reaches or exceeds a predefined proportion threshold, the second predefined pressure value being lower than the first predefined pressure value,
- enabling a gas release (803) from the housing (210) via a third opening (23) of the cryogenic system (2) as long as the inert fluid proportion inside the housing is lower than the predefined proportion threshold, when the pressure inside the housing (210) exceeds a third predefined pressure value, the third predefined pressure value being lower than the first predefined pressure value and equal to or lower than the second predefined pressure value.

14. The method according to claim 13 further comprising steps of:
- activating (805) the thermal coupling system when the inert fluid proportion inside the housing reaches or exceeds the predefined proportion.
